# EUROPÄISCHE PATENTANMELDUNG

(11) **EP 0 544 180 A1**
(43) Veröffentlichungstag der Anmeldung: **02.06.1993**
(21) Anmeldenummer: 92119641.6
(22) Anmeldetag: 17.11.1992
(51) Int. Cl.: H03B 5/18, H01P 7/04

(54) **Abstimmbarer Mikrowellenoszillator**

(30) Priorität: 26.11.1991 DE 4138859
(71) Anmelder: SIEMENS AKTIENGESELLSCHAFT, D-80333 München (DE)
(72) Erfinder: Elias, Holger, W-8034 Germering (DE)

(57) **Zusammenfassung**

Mittels einer Kapazitätsdiode abstimmbare Mirkowellenoszillatoren weisen für Schwingfreuqenzen von maximal 1 GHz als frequenzbestimmendes Glied häufig einen keramischen Koaxialresonator auf, bei dem an einer Stirnseite die Metallisierung entfernt und dort die Kapazitätsdiode angeschlossen ist. Bei Frequenzen oberhalb von 1 GHz, also insbesondere bei Frequenzen um 2,5 GHz, kommt es zu störenden Resonanzen und damit zu ungewollten Schwingfrequenzen durch den Serienresonanzeffekt der Kapazität der Abstimmdiode mit ihrer Anschlußinduktivität und durch die mechanischen Abmessungen des keramischen Koaxialresonators. Erfindungsgemäß wird deshalb der Emitteranschluß des Oszillatortransistors über einen Koppeldraht mit dem Innenraum des keramischen Koaxialresonators verbunden und die Kapazitätsdiode am anderen Ende des Koppeldrahtes angeschlossen.

## Beschreibung

Die Erfindung betrifft einen abstimmbaren Mikrowellenoszillator entsprechend dem Oberbegriff des Anspruchs 1.

Abstimmbare Mikrowellenoszillatoren enthalten neben der mit einer Abstimmspannung beaufschlagten Kapazitätsdiode gelegentlich einen keramischen Koaxialresonator als frequenzbestimmendes Bauteil. Derartige keramische Koaxialresonatoren sind dielektrische Bauteile, die rohrförmig als Rund- oder Rechteckstäbe mit entsprechender Öffnung in der Mitte gesintert und metallisiert werden. Entfernt man die Metallisierung von einer der beiden Stirnseiten, erhält man eine am anderen Ende kurzgeschlossene Koaxialleitung sehr niedriger Impedanz, bei Betrieb als Lambda-Viertel-Leitung erhält man einen Resonator hoher Güte und verglichen mit anderen Leitungsresonatoren sehr geringer Abmessungen.

Wegen der Serienstreuungen der keramischen Koaxialresonatoren und wegen der Toleranzen der übrigen Bauteile des Oszillators ist eine elektronische Abstimmung erforderlich, deren Bereich bei Frequenzen von zwei bis drei GHz im Bereich von 20 bis 30 MHz liegen sollte. Zur elektronischen Abstimmung auf die exakte Nominalfrequenz wurde bisher bei Frequenzen unter 1 GHz die jeweilige Kapazitätsdiode zur Abstimmung direkt mit den nichtmetallisierten Stirnseiten des Koaxialresonators verbunden. Bedingt durch die mechanischen Abmessungen des Aufbaus nehmen mit steigender Frequenz insbesondere von den Leitungsinduktivitäten und Kapazitäten herrührende störende Einflüsse zu. Durch den Serienresonanzeffekt der Kapazität der Abstimmdiode mit ihrer Anschlußinduktivität kommt es außerdem bei Frequenzen oberhalb 1 GHz zu parasitären Resonanzen, durch die die Funktion des Koaxialresonators gestört wird, da in Verbindung mit der verwendeten Resonatorschaltung ungewollte Schwingfrequenzen auftreten können. Bei einer Verbindung der zur Abstimmung verwendeten Kapazitätsdiode mit dem Basis- oder dem Kollektoranschluß des Oszillatortransistors verringert sich die Ausgangsamplitude des Oszillators erheblich, bei einer direkten Verbindung der Kapazitätsdiode mit dem keramischen Koaxialresonators ergibt sich ein stark eingeschränkter Abstimmbereich, so daß beide mögliche Varianten keine Verbesserung der Funktion des Oszillators bei Schwingfrequenzen oberhalb von 2 GHz ergeben.

Die Aufgabe bei der vorliegenden Erfindung besteht also darin, einen Mikrowellenoszillator der eingangs erwähnten Art anzugeben, der auch bei Schwingfrequenzen im Bereich von 2 bis 3 GHz stabil arbeitet und einen ausreichend großen Abstimmbereich aufweist.

Erfindungsgemäß wird die Aufgabe durch einen Oszillator der eingangs erwähnten Art gelöst, der durch die Kennzeichen des Patentanspruchs 1 angegebenen Merkmale weitergebildet ist. In den weiteren Patentansprüchen sind bevorzugte Weiterbildungen des erfindungsgemäßen Mikrowellenoszillators beschrieben, die sich durch eine große mögliche Kapazitätsänderung auszeichnen, so daß Toleranzen der aktiven Schaltung nur untergeordneten Einfluß auf die Schwingfrequenz aufweisen, und auch der Einsatz von preiswerten Halbleiterbauteilen, also der Kapazitätsdiode und des verwendeten Hochfrequenztransistors im Plastikgehäuse sowie von sogenannten MELF-Widerständen anstelle von Chipwiderständen möglich ist.

Die Erfindung soll im folgenden anhand eines in der Zeichnung dargestellten Ausführungsbeispiels näher erläutert werden, dabei zeigt
Fig. 1 den erfindungsgemäßen abstimmbaren Mikrowellenoszillator
Fig. 2 einen in Fig. 1 enthaltenen keramischen Koaxialresonator.

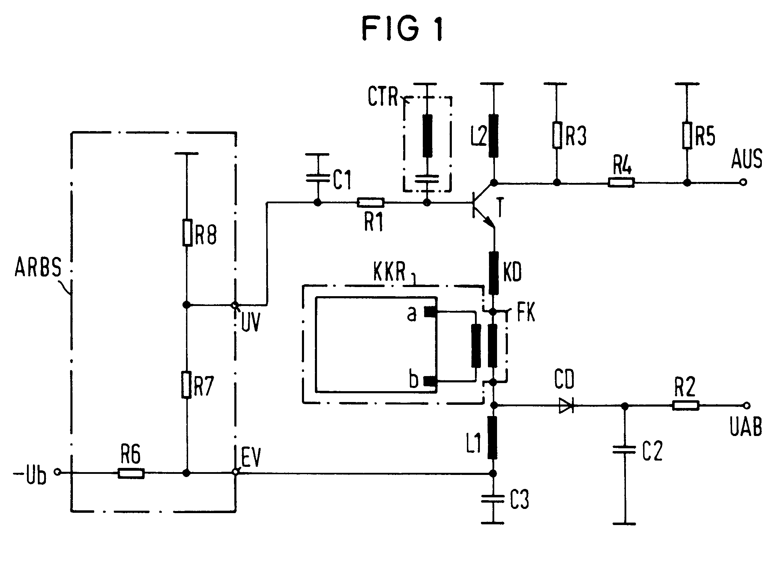

Die Fig. 1 zeigt den abstimmbaren Mikrowellenoszillator, der als aktives Bauteil einen handelsüblichen Hochfrequenztransistor T bzw. vom Typ BFR 92 aufweist, dessen Basisanschluß über einen ersten Widerstand R1 mit einem Anschluß UV für die Basisvorspannung einer Anordnung ARBS zur Arbeits- und Stabilisierung verbunden ist. In die Verbindung zwischen erstem Widerstand R1 und Vorspannungsanschluß UV ist ein erster Kondensator C1 nach Bezugspotential eingeschaltet, in die Verbindung vom ersten Widerstand R1 zum Basisanschluß des Transistors T ist ein Trimmer in Form eines sogenannten Gigatrim nach Bezugspotential eingeschaltet. Auch den Gigatrim-Abstimmkondensator, dessen Kapazität und Anschlußinduktivität einen Serienkreis nahe der Schwingfrequenz bildet, wird der Frequenzbereich, in dem am Emitteranschluß eine negative Impedanz erzeugt wird, eingestellt.

Der Kollektoranschluß des Hochfrequenztransistors T ist über einen Koppeldraht KD mit dem Feld des keramischen Koaxialresonators KKR verbunden, die Induktivitäten FK stellen dabei die Feldkopplung dar. Über den Koppeldraht KD ist der Emitteranschluß des Hochfrequenztransistors T mit dem einen Anschluß einer Kapazitätsdiode CD sowie mit dem einen Anschluß einer ersten Induktivität L1 verbunden. Der andere Anschluß der Kapazitätsdiode CD ist über einen zweiten Kondensator C2 mit Bezugspotential und über einen zweiten Widerstand R2 mit einem Anschluß UAB für eine Abstimmspannung verbunden. Der andere Anschluß der ersten Induktivität L1 ist über einen dritten Kondensator T3 mit Bezugspotential sowie mit einem Anschluß EV für den Emitterstrom der Anordnung ARBS zur Arbeitspunktstabilisierung verbunden.

Der Kollektoranschluß des Hochfrequenztransistors T ist über eine zweite Induktivität L2 mit Bezugspotential sowie über ein Pi-Glied aus einem dritten, vierten und fünften Widerstand R3, R4, R5 mit dem Ausgangsanschluß AUS verbunden.

Die Anordnung zur Arbeitspunktstabilisierung ARBS kann wie beim Ausführungsbeispiel dargestellt, aus einem Spannungsteiler bestehen, der einen sechsten Widerstand R6 enthält, dessen einer Anschluß mit einem Anschluß - Ub für die Betriebsspannung und dessen anderer Anschluß mit dem einen Anschluß eines siebten Widerstandes R7 sowie mit dem Anschluß EV für den Emitterstrom des Hochfrequenztransistors T verbunden ist. Der andere Anschluß des siebten Widerstandes R7 ist dann mit dem Anschluß UV für die Basisvorspannung des Hochfrequenztransistors T sowie über einen achten Widerstand R8 mit Bezugspotential verbunden. Die Anordnung zur Arbeitspunktstabilisierung kann aber auch bei sehr hohen Ansprüchen an die zu stabilisierenden Spannungen bzw. Ströme als geregelte Stromversorgungseinheit aufgebaut sein, die monolithisch integriert ist.

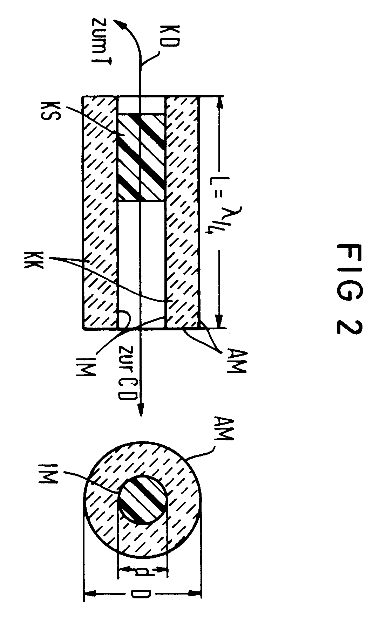

Der in Fig. 2 dargestellte keramische Koaxialresonator ist aus einem handelsüblichen gesinterten und auf seinen inneren und äußeren Oberflächen metallisierten Rohrkörper mit dem Außendurchmesser D und dem Innendurchmesser d dadurch erzeugt, daß an der hinteren Stirnfläche die äußere Metallisierung AM entfernt wurde und ein etwa 1 mm starker Koppeldraht mittig durch die Öffnung des Rohrkörpers geführt und von einem dielektrischen Kunststoffstück KS innerhalb der inneren Metallisierung IM gehalten wird, wobei die Länge L des Rohrkörpers durch dessen Wirkung als Lambda-Viertel-Resonator für den Oszillator zunächst frequenzbestimmend ist.

Die Funktion des erfindungsgemäßen Mikrowellenoszillators beruht ganz wesentlich darauf, daß die Kapazitätsdiode zur Abstimmung nicht direkt mit dem keramischen Koaxialresonator, beispielsweise mit dessen äußerer metallisierter Fläche oder mit dem Basis- oder Kollektoranschluß des Hochfrequenztransistors, sondern über eine Feldkopplung mit dem Koaxialresonator verbunden ist.

Der Koppeldraht nimmt dabei nahezu das gesamte äußere Feld des Koaxialresonators auf, so daß sich nahe der Resonanzfrequenz - also im Bereich von etwa +/- 100 MHz um diese die neue Struktur fast identisch zu der Anordnung mit einem Koaxialresonator mit elektrischer Kontaktierung in Serie mit der Induktivität des Koppeldrahtes verhält. Wird nun diese Oszillatoranordnung im Bereich von 60 bis 90 MHz oberhalb der Lambda-Viertel-Resonanz eines 2,5 GHz Koaxialresonators betrieben, dann ist nach wie vor eine große Kapazitätsänderung über der Frequenz gewährleistet, ohne daß Toleranzen der anderen Bauteile des Mikrowellenoszillators wesentlichen Einfluß auf die Schwingfrequenz ausüben.

Der Koppeldraht ist nach dem Koaxialresonator mit der Reihenschaltung aus der Kapazitätsdiode und dem den Frequenzgang linearisierenden zweiten Kondensator C2 sowie mit dem zweiten Widerstand R2 und der ersten Induktivität L1 verbunden. Dadurch ergibt sich ein vorteilhafter kompakter Aufbau, der neben geringem Platzbedarf und kurzen Leitungswegen unempfindlich gegen unerwünschte Kopplungen ist.

Als passive Bauteile konnten neben Chipkondensatoren die bereits erwähnten MELF-Widerstände verwendet werden, bei denen es sich um mit Kappen ohne Anschlußdrähten versehene hochfrequenztaugliche Metallschichtwiderstände handelt, die gegenüber Chipwiderständen vergleichsweise preisgünstig sind.

## Patentansprüche

1. Abstimmbarer Mikrowellenoszillator mit einem bipolaren Hochfrequenztransistor, einem keramischen Koaxialresonator und einer Kapazitätsdiode, die mit einem Anschluß für eine Abstimmspannung verbunden ist,
**dadurch gekennzeichnet,**
daß an einer Stirnseite des keramischen Koaxialresonators (KKR) die Metallisierung entfernt und dort ein unmittelbar mit dem Emitteranschluß des HF-Transistors (T) verbundener Koppeldraht (KD) in den keramischen Koaxialresonator (KKR) geführt ist, daß der Koppeldraht (KD) am anderen Ende des keramischen Koaxialresonators (KKR) mit der Kapazitätsdiode (CD) und über eine erste Induktivität (L1) mit einer Quelle für den Emitterstrom des Hochfrequenztransistors (T) verbunden ist, daß ein sogenannter Gigatrim-Kondensator vorgesehen ist, dessen einer Anschluß mit dem Basisanschluß des Hochfrequenztransistors (T) und dessen anderer Anschluß mit Bezugspotential verbunden ist, daß der Kollektoranschluß des Hochfrequenztransistors (T) über eine zweite Induktivität (L2) mit Bezugspotential und über ein Widerstands-Pi-Glied mit einem Ausgangsanschluß (AUS) verbunden ist und daß die Schwingfrequenz des Oszillators wenig oberhalb der Lambda-Viertel-Resonanz des keramischen Koaxialresonators (KKR) eingestellt ist.

2. Abstimmbarer Mikrowellenoszillator nach Patentanspruch 1,
**dadurch gekennzeichnet,**
daß der Basisanschluß der Hochfrequenztransistors (T) über einen ersten Widerstand mit einem Anschluß (UV) für eine Basisvorspannung einer Anordnung (ARBS) zur Arbeitspunktstabilisierung und außerdem über einen, dem ersten Widerstand (R1) nachgeschalteten ersten Kondensator (C1) mit Bezugspotential verbunden ist.

3. Abstimmbarer Mikrowellenoszillator nach Patentanspruch 1,
**dadurch gekennzeichnet,**
daß der dem Koppeldraht (KD) abgewandte Anschluß der Kapazitätsdiode (CD) über einen zweiten Kondensator (C2) mit Bezugspotential und über einen zweiten Widerstand (R2) mit einem Anschluß (UAB) für eine Abstimmspannung verbunden ist.

4. Abstimmbarer Mikrowellenoszillator nach Anspruch 1,
**dadurch gekennzeichnet,**
daß der Kollektoranschluß des Hochfrequenztransistors über eine zweite Induktivität (L2) und einem dazu parallelgeschalteten dritten Widerstand (R3) mit Bezugspotential und außerdem direkt mit einem ersten Anschluß eines vierten Widerstandes (R4) verbunden ist, wobei der andere Anschluß dieses Widerstandes (R4) über einen fünften Widerstand (R5) mit Bezugspotential und außerdem mit dem Ausgangsanschluß (AUS) verbunden ist.
